Europäisches Patentamt

(19) European Patent Office

Office européen des brevets

(11) Publication number : **0 234 891 B1**

(12) **EUROPEAN PATENT SPECIFICATION**

(45) Date of publication of patent specification :
26.06.91 Bulletin 91/26

(51) Int. Cl.⁵ : **H01L 27/10**

(21) Application number : **87301506.9**

(22) Date of filing : **20.02.87**

(54) Semiconductor memory devices.

(30) Priority : **20.02.86 JP 36361/86**
**03.03.86 JP 45822/86**

(43) Date of publication of application :
**02.09.87 Bulletin 87/36**

(45) Publication of the grant of the patent :
**26.06.91 Bulletin 91/26**

(84) Designated Contracting States :
**DE FR GB**

(56) References cited :
**EP-A- 0 149 799**
**EP-A- 0 171 131**

(56) References cited :
**PATENT ABSTRACTS OF JAPAN, vol. 8, no.**
**272 (E-284)[1709], 13th December 1984; &**
**JP-A-59 141 262**
**PATENT ABSTRACTS OF JAPAN, vol. 9, no.**
**185 (E-332)[1908], 31st July 1985; & JP-A-60 54**
**472**

(73) Proprietor : **FUJITSU LIMITED**
**1015, Kamikodanaka Nakahara-ku**
**Kawasaki-shi Kanagawa 211 (JP)**

(72) Inventor : **Taguchi, Masao**
**4-3-4-201, Araisono**
**Sagamihara-shi Kanagawa 228 (JP)**

(74) Representative : **Fane, Christopher Robin King**
**et al**
**HASELTINE LAKE & CO. Hazlitt House 28**
**Southampton Buildings Chancery Lane**
**London, WC2A 1AT (GB)**

Note : Within nine months from the publication of the mention of the grant of the European patent, any person may give notice to the European Patent Office of opposition to the European patent granted. Notice of opposition shall be filed. in a written reasoned statement. It shall not be deemed to have been filed until the opposition fee has been paid (Art. 99(1) European patent convention).

# Description

## SEMICONDUCTOR MEMORY DEVICES

The present invention relates to semiconductor memory devices for use, for example, in dynamic random access memories (DRAMs).

Memory devices have been proposed which include a trench capacitor of a MOS structure, such a capacitor being fabricated in the form of a trench. A capacitor having such a trench-like structure can have a relatively large effective area, and accordingly it is possible to provide a compact trench capacitor having a large storage capacitance.

In a prior art memory having a trench capacitor, for operational reasons the concentration of impurities in the semiconductor substrate is sometimes made low, for example a substrate impurity concentration of $2 \times 10^{15}$ cm$^{-3}$. In such a device, a punch-through phenomenon can occur between the trench capacitor of one memory cell and the trench capacitor of an adjacent memory cell, owing to an extension of the depletion layer formed in the substrate. This punch-through phenomenon is undesirable, because it can result in electrical coupling between adjacent trench capacitors, and accordingly stored data can be lost and the memory system can become less reliable.

In one form of prior art memory employing a trench capacitor in each memory cell, the so-called Hi-C capacitor structure can be adopted in which one plate (the cell plate) of the capacitor is maintained at a voltage half-way between Vcc and Vss. However, in use of such a device a diffused layer is induced around the trench to provide the storage electrode, reducing the effective distance between adjacent capacitors. Thus, this structure leads to an increased possibility of punch-through between cells.

Also, in a prior art memory device having a trench capacitor, a depletion layer extends widely around the storage electrode in the substrate, so that minority carriers produced in the substrate by any means (for example by incidence of an alpha-particle) are readily captured in the depletion layer and drawn to the storage electrode, whereby the possibility of soft errors due to alpha ray irradiation is increased.

Further, in a prior art memory having a trench capacitor with an inversion layer type electrode, the maximum voltage written into a cell is limited by the cell-plate voltage and lowered by the threshold voltage loss associated with the presence of inversion layer electrons. For example, the maximum available write voltage can be reduced to about 1 volt lower than the power source voltage. This reduction of the write voltage from the power source voltage is also undesirable.

EP-A-0149799 discloses a semiconductor memory device having a transistor associated with a trench capacitor in which the storage electrode is provided by a central conductive portion within the trench rather than by an inversion layer extending around the outside of the trench in the semiconductor substance. This storage electrode is surrounded by a dielectric layer which is in turn surrounded by a second conductive electrode (cell plate) of the capacitor, thereby reducing the occurrence of the punch-through, between adjacent capacitors, and soft errors.

However, in the disclosed prior device the trench capacitor is spaced apart from an adjacent source or drain region of the associated transistor, presumably to prevent junction breakdown occurring between that region and the cell plate of the capacitor. The provision of such spacing restricts the overall cell density that can be achieved in such a device.

According to the present invention there is provided a semiconductor memory device comprising :

a semiconductor substrate of one conductivity type ;

a transistor formed on the said substrate and having an active portion serving as a source or drain, which active portion is of the opposite conductivity type ; and

a storage capacitor comprising a first relatively conductive member, consisting of a layer provided on the substrate within a recess formed therein, a dielectric layer covering the said first relatively conductive member in the recess, and a second relatively conductive member filling a remaining portion of the recess, so as to be surrounded by the said dielectric layer ; there being an electrical connection between the said second relatively conductive member and the said active portion of the transistor ;

characterised in that an internal boundary region of the said recess, adjacent to the mouth thereof, is not covered by the said layer constituting the first relatively conductive member, but part of the said dielectric layer extends over that region, and the said active portion of the transistor provides a part of the said internal boundary region, which part is spaced from the nearest edge regions of the first relatively conductive member by a predetermined intervall so that a relatively insulating portion of the device isolates the said active portion from the said first relatively conductive member.

Reference will now be made, by way of example, to the accompanying drawings, in which :

Fig. 1 shows a vertical sectional view of part of a previously-proposed dynamic random access memory having a trench capacitor ;

Fig. 2 shows a plan view of a part of a memory device according to a first embodiment of the present invention ;

Fig. 3 shows a vertical sectional view of the Fig. 2 device, corresponding to line III-III in Fig. 2 ;

Figs. 4A, 5A, 6A, 7A, 8A, and 9A are plan views illustrating a process for making the device of Fig.

2 ;

Figs. 4B, 5B, 6B, 7B, 8B, and 9B are vertical sectional views corresponding to Figs. 4A, 5A, 6A, 7A, 8A, and 9A respectively ;

Fig. 10A shows a schematic vertically sectioned view for explaining an alternative structure of the device of Figs. 2 and 3 ;

Fig. 10B shows a view corresponding to that of Fig. 10A but illustrating the actual structure of the device of Figs. 2 and 3 ;

Fig. 11 also shows a plan view of an embodiment of the present invention ;

Fig. 12 shows a vertical sectional view of the embodiment of Fig. 11, corresponding to line XII-XII in Fig. 11 ;

Fig. 13 shows a plan view of a further embodiment of the present invention ; and

Fig. 14 shows a vertical sectional view of the embodiment of Fig. 13, corresponding to line XIV-XIV in Fig. 13.

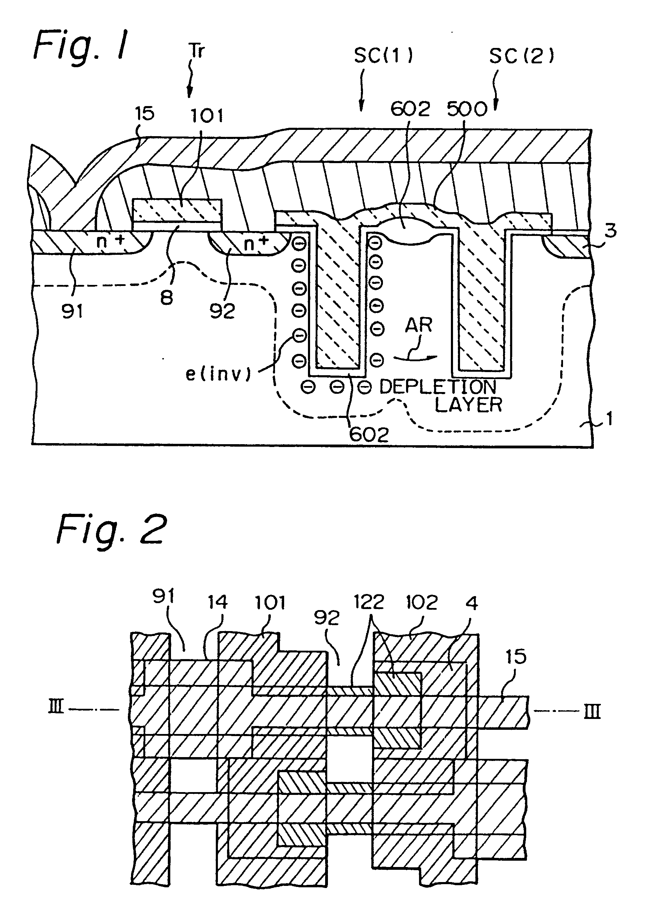

Before describing the preferred embodiments of the present invention, a previously-proposed dynamic random access memory (DRAM) having a trench capacitor, as shown Fig. 1, will be described. The DRAM of Fig. 1 includes a semiconductor substrate 1 of p type silicon, an isolation layer 3 of silicon dioxide delimiting a cell region, and a dielectric layer 602, and a cell plate 500, or counter electrode, consisting of polycrystalline silicon (polysilicon). Inversion layer electrons e(inv) exist in the substrate 1 around the dielectric layer 602. The storage capacitor SC(1) is formed by the inversion layer electrons e(inv), the dielectric layer 602, and the cell plate 500. The DRAM of Fig. 1 also includes a gate dielectric layer 8, a word line 101 consisting of polysilicon, and regions 91 and 92 into which a high impurity concentration has been introduced to form $n^+$ type source and drain regions. A MIS field effect transistor Tr is constituted by active regions 91 and 92, one being a source region and the other a drain region, and the word line 101 as the gate. The DRAM of Fig. 1 also includes a bit line 15 which is in contact with the active region 91 and is arranged perpendicularly to the word line 101. The storage capacitator SC(1) and the active region 91 of the MIS transistor Tr are connected by inversion layer electrons e(inv). Thus, the storage electrode for storing data in the form of an electric charge is constituted by the region of the inversion layer electrons e(inv). In the DRAM of Fig. 1, a depletion layer is formed in the substrate 1 as shown by the broken line in Fig. 1.

In the DRAM of Fig. 1, the storage capacitor SC(2) of the adjacent memory cell is located adjacent to the storage capacitator SC(1) of the memory cell in question. The arrow AR in Fig. 1 represents a region of the DRAM in which punch-through phenomena may occur.

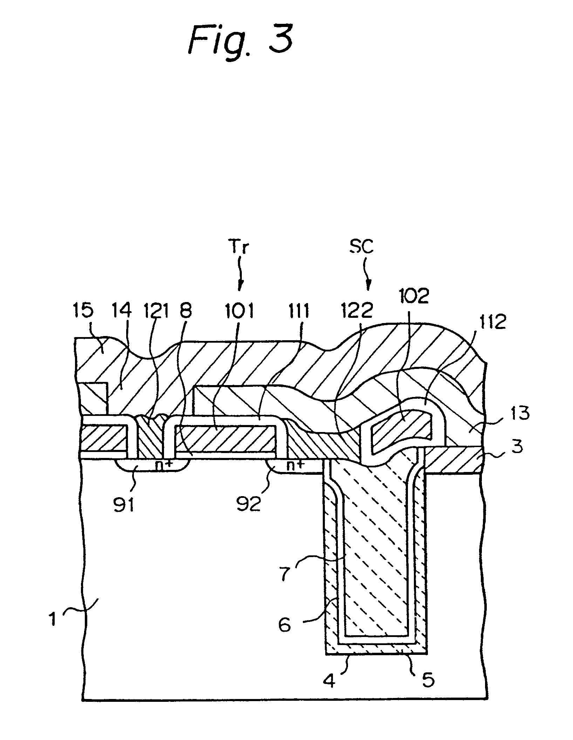

A dynamic random access memory having a trench capacitor according to a preferred embodiment of the present invention is shown in Figs. 2 and 3. A sectional view of Fig. 2, taken along line III-III, is shown in Fig. 3.

The memory of Figs. 2 and 3 includes a silicon semiconductor substrate 1 of one type of conductivity, for example p-type, an insulation layer 3 of, for example, silicon dioxide, for defining a cell region, and a trench 4 formed in the substrate 1.

In the memory of Figs. 2 and 3, a first conductive layer 5 of $p^+$ type polycrystalline silicon (polysilicon), formed on the entire internal boundary (inner) surface of the trench 4 except for a boundary region adjacent to the opening (mouth) of the trench 4, constitutes a cell plate (counter electrode) of a storage capacitor. A dielectric layer 6 of silicon nitride $Si_3N_4$ is also provided. A second conductive layer of an $n^+$ type polysilicon fills the body of the trench 4 within the dielectric layer 6 to provide a storage electrode 7 of the storage capacitor. The storage capacitor is thus constituted by the cell plate 5, the dielectric layer 6, and the storage electrode 7.

The memory of Figs. 2 and 3 also includes a silicon dioxide $SiO_2$ gate dielectric layer 8, $n^+$ type source or drain regions 91 and 92, a gate electrode 101 of titanium silicide $TiSi_2$ forming part of the word line of the memory cell concerned, and a gate electrode forming part of the word line of an adjacent memory cell. The p-type silicon substrate 1, the gate dielectric layer 8, the $n^+$ type source and drain regions 91 and 92, and the word line 101 constitute a transistor Tr of the memory cell, the active region 92 of which transistor provides a part of the internal boundary region of the trench, adjacent to the mouth thereof.

The memory of Figs. 2 and 3 also includes a silicon dioxide $SiO_2$ insulator layer 111, and a third conductive layer 122 of $n^+$ type polysilicon which electrically connects the source or drain region 92 to the storage electrode 7 of the storage capacitor.

The memory of Figs. 2 and 3 further includes an inter-layer insulator layer 13, a window 14 for a wiring contact, and a bit line 15 of aluminum which is electrically connected to the source or drain region 91 and extends in the direction perpendicular to the direction of the word line on the inter-layer insulator layer.

With the type of trench capacitor shown in Figs. 2 and 3, the electrical connection between the source or drain region 92 and the storage electrode 7 of the storage capacitor is realized by the third conductive layer 122. The first conductive layer 5, in direct contact with the substrate, forms the cell plate of the storage capacitor. This arrangement of the storage electrode 7 surrounded by the cell plate 5 is the reverse of that of the Figure 1 arrangement.

In the memory of Figs. 2 and 3, the third conductive layer 122, which connects the source or drain region 92 with the storage electrode 7, can be formed by self-alignment techniques (rather than a masking process) using a process involving selective growth of polysilicon on the exposed parts of the silicon surface between the word lines 101 and 102. The electrical separation of the source or drain region 92 from the cell plate 5 is realized by the source-drain junction.

In the memory of Figs. 2 and 3, a leakage of the stored charge due to punch-through phenomena between adjacent storage capacitors can be prevented. Also, disturbance of the stored data in one capacitor caused by charging or discharging of an adjacent storage capacitor through static coupling between capacitors can be avoided.

Also, the possibility of soft-errors is reduced by virtue of the Figure 3 structure in which the storage electrode is surrounded by the insulation layer and also the cell-plate, and thus the depletion layer does not extend to reach to neighbouring cells. Also, the reduction of the write voltage from the power source voltage can be prevented, since the storage capacitor consists of the $n^+$ type polysilicon, the dielectric layer, and the $p^+$ type polysilicon ; an inversion layer, the formation of which results in threshold voltage loss, is not used.

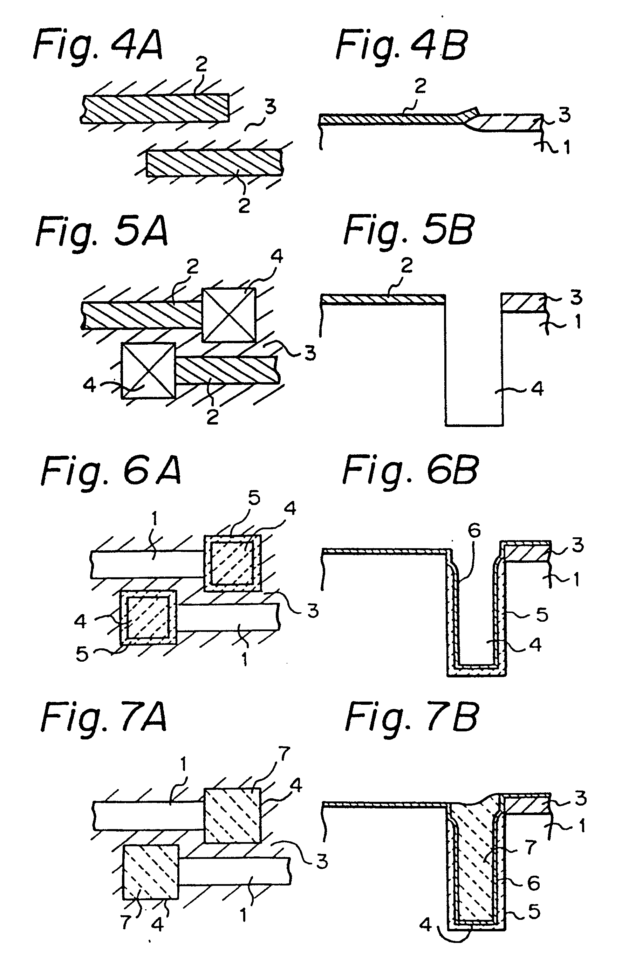

An example of a process for producing the memory of Figs. 2 and 3 is illustrated in Figs. 4A, 4B, 5A, 5B, 6A, 6B, 7A, 7B, 8A, 8B, 9A, and 9B. Figures 4A to 9A represent plan views, and Figs. 4B to 9B represent corresponding cross-sectional views.

As shown in Figs. 4A and 4B, an oxidation masking layer 2, consisting of, for example, silicon nitride $Si_3N_4$, or a composite layer of silicon nitride $Si_3N_4$ and silicon dioxide $SiO_2$, is formed on an element formation region of the surface of the p-type silicon substrate 1 to enable selective oxidation of the silicon substrate. The silicon substrate 1 is then oxidized, so that a silicon dioxide layer 3 having a thickness of, for example, 4000 angstrom (0.4 μm), is formed as the field isolation layer.

As shown in Figs. 5A and 5B, a trench 4 having a depth of, for example, 3 to 4 μm, is formed in the non-oxidized region including the field insulation layer 3, by the usual lithographical process and reactive ion etching (RIE) process.

As shown in Figs. 6A and 6B, a polycrystalline silicon (polysilicon) layer doped to be $p^+$ type is grown to a thickness of, for example, 2000 angstrom, on the entire surface of the substrate 1 including the inner surface of the trench 4. Then, the polysilicon layer in the other region except for the inner surface of the trench 4 is eliminated by anisotropic dry etching, such as the RIE process, in the direction perpendicular to the surface of the substrate. Thus, the $p^+$ type polysilicon layer 5 is formed in the trench 4 as the first conductive layer.

A portion of the polysilicon layer 5 in the upper boundary region of the trench, in the vicinity of the mouth thereof, is selectively removed down to a depth of, for example, 0.5 μm, from the mouth of the trench by, for example, an over-etching process. This removal is advantageous for enhancing the breakdown voltage of the junction with the adjacent source or drain region of the transistor.

The formation of the $p^+$ type polysilicon layer 5 is directed to the establishment of a region having the same conduction type as the substrate and a high impurity concentration on the inner surface of the trench 4 so that the substrate serves a cell plate function.

The oxidation masking layer 2 is then removed to expose the surface of the silicon, and a dielectric layer 6 of silicon nitride $Si_3N_4$, silicon dioxide $SiO_2$, or a composite of these substances, having a thickness of, for example, 100 angstrom, is formed on the entire surface of the substrate including the inner surface of the trench 4 by an oxidation or growth process. It is known that the insulation breakdown voltage of this oxidation-resistant coating is enhanced by annealing in an oxygen atmosphere.

The thus-formed layer constitutes the dielectric layer 6 of the storage capacitor.

As shown in Figs. 7A and 7B, an $n^+$-type doped polysilicon layer is grown on the substrate 1 and within the trench 4 to a thickness necessary to fill the trench 4. An etching process, in which the predominant etching direction is in the direction perpendicular to the main surface of the substrate, is then applied so as to leave just the illustrated amount of $n^+$ type polysilicon material 7, providing a second conductive member acting as the storage electrode, recessed only slightly into the trench 4.

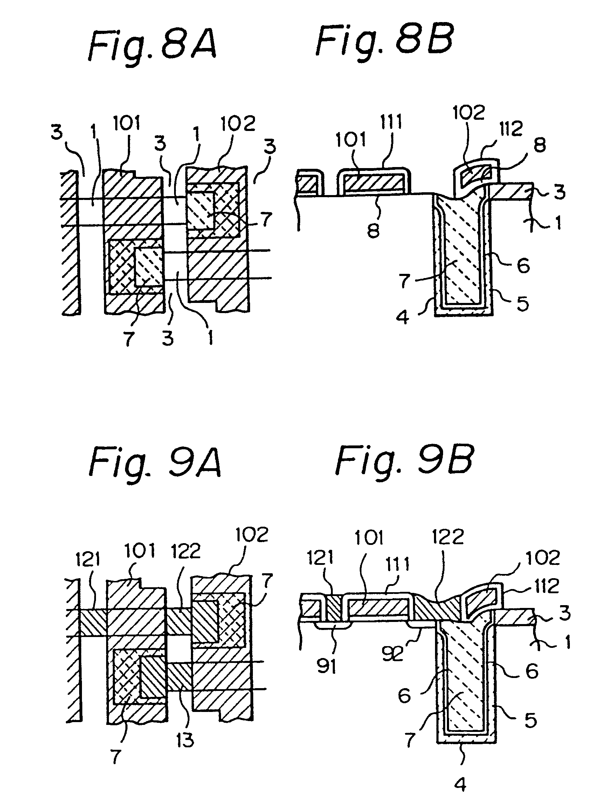

As shown in Figs. 8A and 8B, the parts of the silicon nitride $Si_3N_4$ dielectric layer 6 outside the trench 4 are removed to expose the surface of the silicon substrate 1. Then, the surface of the substrate 1 is oxidized by the usual process for forming a MOS transistor to form a silicon dioxide $SiO_2$ gate dielectric layer 8 having a thickness of, for example, 280 angstroms. When oxidation is carried out at a relatively low temperature, for example 900°C, the thickness of the silicon dioxide layer 8 on the surface of the $n^+$ type polysilicon member 7 as the storage electrode becomes, for example, 600 angstrom.

Gate material such as titanium silicide $TiSi_2$ having a thickness of, for example, 2000 angstroms, is deposited on the main surface of the wafer. This gate material is then coated with a silicon dioxide layer 111 having a thickness of, for example, 1500 angstrom, and patterned so that a pattern of a word line of titanium silicide having the silicon dioxide layer in the upper portion is formed.

Then, a silicon dioxide layer 112 having a thickness of, for example, 1500 angstrom is again deposited on the main surface. Hence, the silicon dioxide layer 111 or 112 is left on the upper and side surface of the word line 4 by an anisotropic etching process, and thus word lines 101 and 102 of titanium silicide are covered with a silicon dioxide layer. In this case, the portion of the silicon substrate 1 not covered by the word lines and the surface of the polysilicon filling the trench 4 are exposed.

As shown in Figs. 9A and 9B, phosphor or arsenic is ion-implanted selectively, using the word lines constituting the gate electrodes as a mask, to form $n^+$ type source and drain regions 91 and 92. At the same time, a highly n-type impurity doped region is formed in the $n^+$ type polysilicon member 7 filled in the trench 4.

Then, a selective growth of a polysilicon layer having a thickness of, for example, 2000 angstroms and including a high concentration of phosphor or arsenic as dopant, is carried out on the substrate 1 by a selective vapour phase growth process.

The polysilicon layer is not grown over the silicon dioxide layers 111, 112, and 3, but provides a third conductive layer including portions 121 and 122 of $n^+$ type polysilicon formed on the source or drain regions 91 and 92 and the upper region of the $n^+$ type polysilicon member 7 (the storage electrode). The $n^+$ type polysilicon layer is not grown on the exposed uppermost edge of the dielectric layer 6, but since the thickness of the dielectric layer is very small, for example 100 angstrom, the portion 122 of the polysilicon layer extending between the source or drain region 92 and the storage electrode 7 is continuous across that uppermost edge, so that the source or drain region 92 is electrically connected to the storage electrode 7.

Subsequently, an inter-layer insulation layer 13 formed on the entire surface of the substrate, a contact window 14 is opened over the source or drain region 91 where a bit line is to be in contact with a memory cell and a bit line 15 consisting of, for example, aluminum, is formed to complete the structure shown in Figs. 2 and 3.

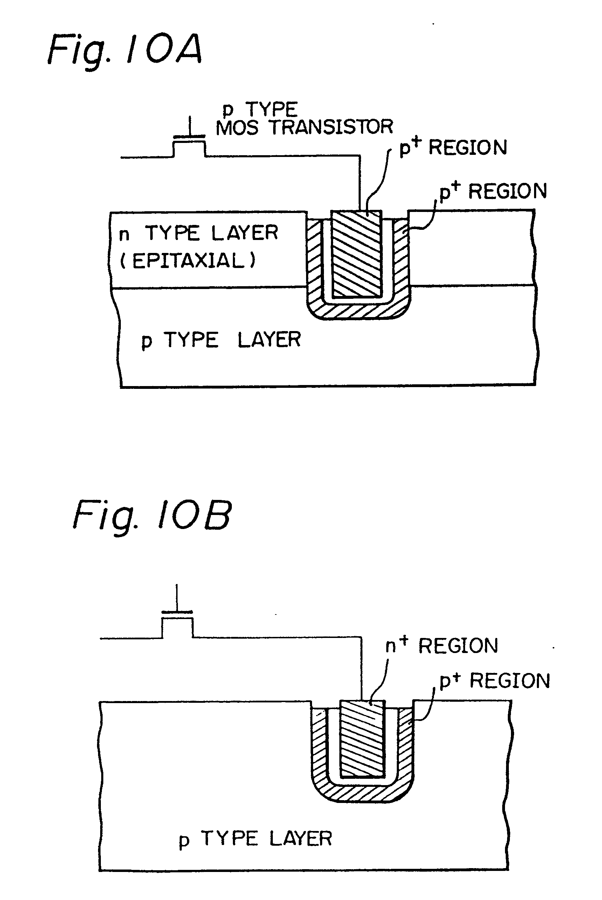

Instead of the structure of the dynamic random access memory shown in Figs. 2 and 3, it is possible to adopt an alternative structure in which a lower part of the storage capacitor is formed in a p-type substrate and an upper part thereof in an n-type layer epitaxially grown on the p-type substrate, as shown schematically in Fig. 10A. In the structure of Fig. 10A, the transistor is a p-type MOS transistor, the storage electrode is $p^+$ type, and the first conductive layer (cell plate) is $p^+$ type.

The structure of the memory device of Figs. 2 and 3 is shown diagrammatically, by way of comparison, in Fig. 10B.

Instead of the structure shown in Figs. 2 and 3 in which the substrate is p type and the source and drain regions and the storage electrode are $n^+$ type, it is possible to adopt an alternative structure in which the substrate is n type, and the source and drain regions and the storage electrode are $p^+$ type.

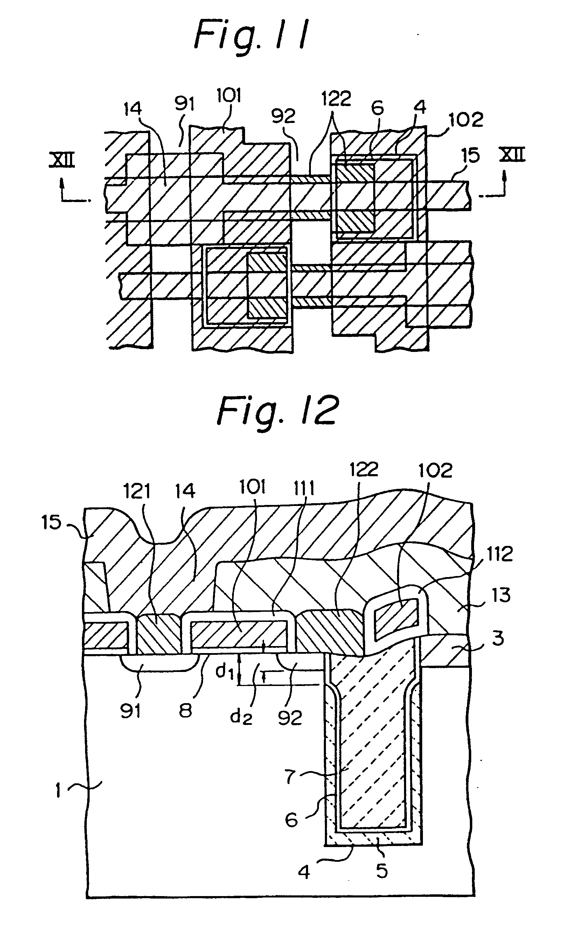

The structure of a dynamic random access memory having a trench capacitor similar to that of the memory of Figures 2 and 3 is shown in greater detail in Figs. 11 and 12. A sectional view of Fig. 11 taken along the line XII-XII is shown in Fig. 12.

The memory of Figs. 11 and 12 is similar in most respects to the Fig. 2 memory.

As shown in Fig. 11, the first conductive layer 5 of $p^+$ type polysilicon covers the entire internal boundary surface of the trench 4 except for a boundary region, adjacent to the opening of the trench 4, of a depth $d_1$, and constitutes the cell plate (counter electrode) of the storage capacitor.

Thus, in the memory of Figs. 11 and 12, the $p^+$ type polysilicon cell plate 5 coated on the internal boundary surface of the trench 4 is limited at its upper end to a depth $d_1$ below the level of the mouth of the trench. The mouth level is a smaller distance $d_2$ above the bottom of the $n^+$ type source or drain region 92. Hence, there is a separation between the source or drain region 92 and the nearest edge regions of the cell plate 5. Accordingly, the $n^+$ type source or drain region 92 having a high dopant concentration does not directly touch the $p^+$ type cell plate 5. Thus the danger of $p^+n^+$ junction breakdown between the cell plate 5 and the source or drain region 92 is substantially avoided, even though that region itself provides a part of the internal boundary region of the trench, adjacent to its mouth, that is not covered by the cell plate 5.

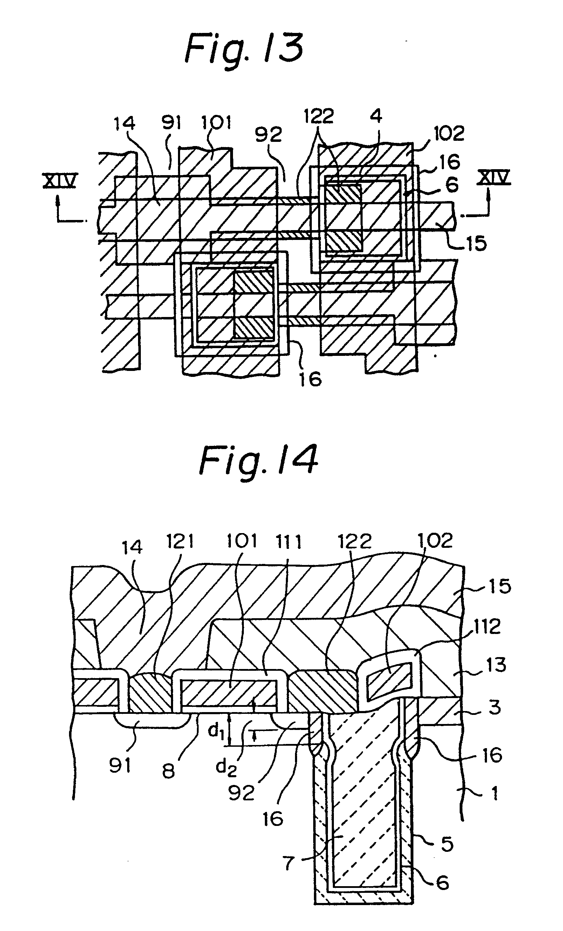

A dynamic random access memory having a trench capacitor according to a further embodiment of the present invention is shown in Figs. 13 and 14. A cross-sectional view of Fig. 13 taken along the line XIV-XIV is shown in Fig. 14.

The structure of the memory of Figs. 13 and 14 is fundamentally the same as that of Figs. 11 and 12, except that a silicon dioxide insulating layer 16, which is formed by thermal oxidation and has a thickness of, for example, 1000 or 2000 angstroms (which is greater than the thickness of the dielectric layer 6), is arranged in a part of each cell between the $n^+$ type source or drain region 92 and the $p^+$ type cell plate 5.

The presence of the silicon dioxide insulating layer 16, which has a considerable tickness and a high breakdown voltage, between the $n^+$ type source or drain region 92 and the $p^+$ type cell plate 5 further enhances the breakdown voltage of the junction with the source or drain region 92.

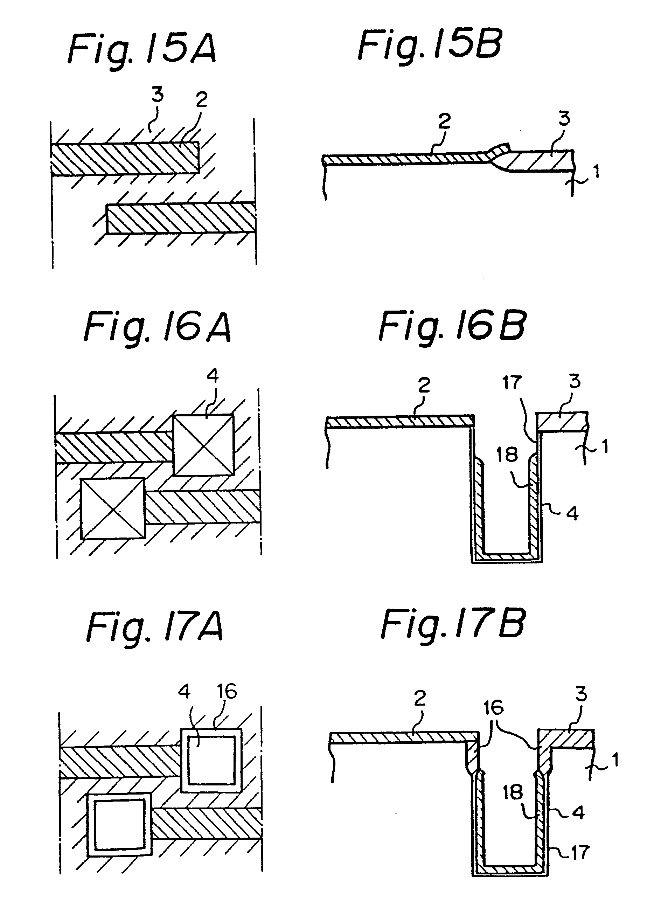

An example of a process for producing the memory of Figs. 13 and 14 is illustrated in Figs. 15A, 15B, 16A, 16B, 17A, 17B, 18A, 18B, 19A, 19B, 20A and 20B. Figures 15A to 20A represent plan views, and Figs. 15B to 20B represent corresponding cross-sectional views.

As shown in Figs. 15A and 15B, an oxidation masking layer 2 for selective oxidation, consisting of, for example, silicon nitride $Si_3N_4$, or a composite layer of silicon nitride $Si_3N_4$ and silicon dioxide $SiO_2$, is formed on an element formation region of the surface of the p type silicon substrate 1. The silicon substrate 1 is then oxidized so that a silicon dioxide layer 3 having a thickness of, for example, 4000 angstrom, is formed as an isolation layer.

As shown in Figs. 16A and 16B, a trench 4 having a depth of, for example, 3 to 4 μm, is formed in the oxidation-resistant region including a portion of the isolation layer 3, by the usual lithographical process and reactive ion etching (RIE) process. Then, thermal oxidization is again carried out, and accordingly a buffer silicon dioxide layer 17 having a thickness of, for example, 300 angstrom, is formed on the internal boundary surface of the trench 4.

A silicon nitride $Si_3N_4$ layer 18 having a thickness of, for example, 1000 angstrom, is then coated on the entire surface by a chemical vapour deposition process, and isotropic etching is carried out by a plasma etching process. Thus, a portion of the silicon nitride $Si_3N_4$ layer 18 on the surface of the substrate and in the vicinity of the opening of the trench is removed, so that the silicon nitride $Si_3N_4$ layer 18 is maintained on the internal boundary surface in the vicinity of the bottom of the trench 4, which functions as an oxidation masking layer.

As shown in Figs. 17A and 17B, selective oxidation is carried out by using the silicon nitride $Si_3N_4$ layer 18 as a mask, so that a silicon dioxide layer 16 having a thickness of, for example, 1000 angstrom, is formed on the internal boundary surface of the trench 4 except for a region in the vicinity of the mouth of the trench 4.

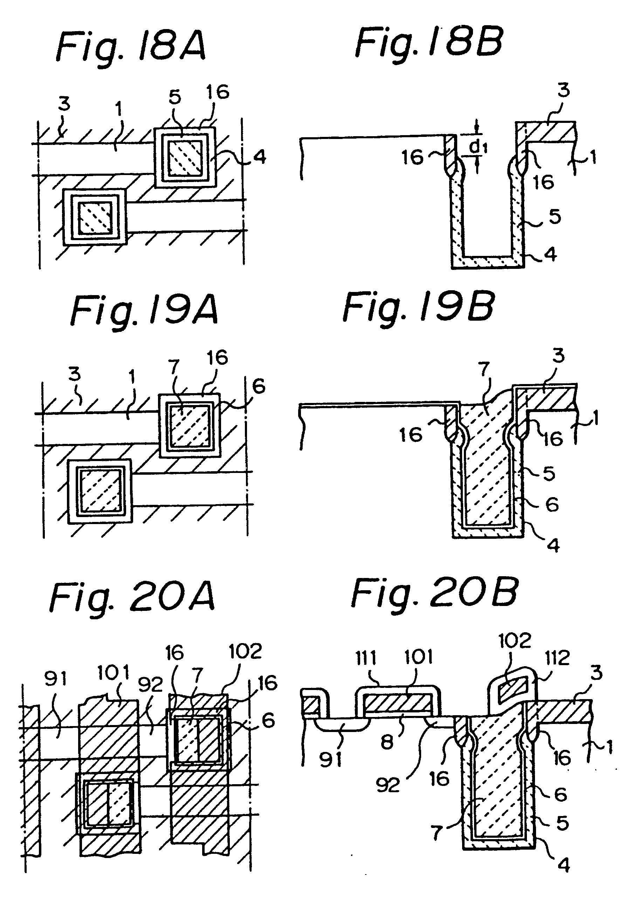

As shown in Figs. 18A and 18B, the silicon nitride $Si_3N_4$ layers 2 and 18 are removed, and the silicon dioxide layer 17 under these silicon nitride $Si_3N_4$ layers is removed to expose the upper surface of p-type silicon substrate 1 and the inner surface of the portion in the vicinity of the bottom of the trench 4. Then, a $p^+$ type polysilicon layer having a thickness of, for example, 1000 angstroms and doped with high concentration boron, is formed on the entire surface of the substrate 1 including the internal boundary surface of the trench 4, by the chemical vapour deposition process. Then, isotropic etching such as plasma etching is carried out, so that the $p^+$ type polysilicon layer 5 is maintained only in the trench 4.

As shown in Fig. 18B, the upper edge of the $p^+$ type polysilicon layer 5 is positioned at a distance $d_1$ lower than the level of the opening of the trench 4, the distance $d_1$ being greater than the thickness of the source or drain region of the transistor. The value of $d_1$ is, for example, 0.2 to 1 μm.

In this case, the $p^+$ type polysilicon layer 5 is formed on the internal boundary surface of the trench 4 in order to form a region which is of the same conductivity type as the substrate 1 and having a high dopant concentration on the internal boundary surface of the trench 4. Thus, a portion of the substrate 1 serves to provide a cell plate function.

As shown in Figs. 19A and 19B, a silicon nitride $Si_3N_4$ layer 6, a silicon dioxide layer 6 or a composite layer 6 of silicon nitride $Si_3N_4$ and silicon dioxide, having a thickness of 100 angstrom, is formed to extend over the entire internal boundary surface of the trench to serve as a dielectric layer, by an oxidation process or a growth process. It is known that the breakdown voltage of such a dielectric layer can be enhanced by annealing the dielectric layer in an oxygen atmosphere.

Then, a polysilicon layer is grown on the substrate 1 including the inside of the trench to a thickness sufficient to fill the remaining portion of the trench. The layer is subsequently doped with arsenic or phosphor by an ion implantation or diffusion process. Then, the polysilicon layer is selectively removed from the substrate by an isotropic etching process to leave an $n^+$ type polysilicon member 7 filling the trench 4 and surrounded by the dielectric layer 6. This $n^+$ type polysilicon member 7 functions as the storage electrode.

As shown in Figs. 20A and 20B, the exposed parts of the dielectric layer 6 of silicon nitride $Si_3N_4$ outside the trench 4 are removed to expose the surface of the silicon substrate. Then, the surface of the substrate 1 is oxidized by the usual process for forming a MOS transistor to form a silicon dioxide $SiO_2$ gate dielectric layer 8 having a thickness of, for example, 280 angstroms. When the oxidation is carried out at a relatively low temperature, for example 900°C, the thickness of the silicon dioxide layer 8 on the surface of the $n^+$ type polysilicon storage electrode 7 becomes, for example, 600 angstrom.

Then, gate material such as titanium silicide $TiSi_2$ having a thickness of, for example, 4000 angstroms is deposited at the main surface, and this gate material is then coated with the silicon dioxide layer 111 having a thickness of, for example, 1500 angstrom, and patterning is carried out, so that the word line of titanium silicide covered by the silicon dioxide layer is formed to the desired pattern.

Subsequently, a silicon dioxide layer 112 having a thickness of, for example, 1500 angstrom, is again deposited on the main surface. Hence, the silicon dioxide layer 111 or 112 is left on the upper and side surface of the pattern of word line by an anisotropic etching process, and thus the word lines 101 and 102 of titanium silicide covered by silicon dioxide are formed. In this case, the portion of the silicon substrate 1 not covered by the word lines and the surface of the polysilicon member 7 filling the trench 4 are exposed.

As shown in Figs. 20A and 20B, phosphor or arsenic is ion-implanted selectively, using the word lines constituting the gate electrodes as the mask, in accordance with the usual process to form $n^+$ type source or drain regions 91 and 92. At the same time, an n type impurity introduction region is formed in the $n^+$ type polysilicon member 7 filling the trench 4.

Then, a selective growth of a polysilicon layer having a thickness of, for example, 4000 angstroms, and including a high-concentration phosphor or arsenic dopant, is carried out on the substrate by a selective vapour phase growth process.

In this case, a polysilicon layer does not grow over the silicon dioxide layers 111, 112, and 3, but a third conductive layer including portions 121 and 122 of n⁺ type polysilicon is formed on the source or drain regions 91 and 92 and the upper region of the n⁺ type polysilicon member 7 (the storage electrode). The n⁺ type polysilicon layer is not grown on the exposed uppermost edge of the dielectric layer 6 or the silicon dioxide insulation layer 16. However, since the thickness of the dielectric layer is very small, for example, 100 angstrom, the portion 122 of the polysilicon layer between the source or drain region 92 and the storage electrode 7 is continuous, so that the source or drain region 92 is electrically connected to the storage electrode 7.

Subsequently, an inter-layer insulation layer 13 is formed over the entire surface of the substrate, a contact window 14 is formed over the source or drain region 91 where a bit line is in contact with a memory cell, and a bit line 15 consisting of, for example, aluminum, is formed to complete the structure shown in Figs. 13 and 14.

As mentioned above with reference to Fig. 10A, instead of the structure of the dynamic random access memory shown in Figs. 11 and 12, or 13 and 14, it is possible to adopt an alternative structure in which a lower part of the storage capacitor is formed in a p-type substrate and an upper part thereof in an n-type layer epitaxially formed over the p-type substrate. In this alternative structure, the transistor is a p-type MOS transistor, the second conductive layer is p⁺ type, and the first conductive layer is p⁺ type.

Also, instead of the structure of the dynamic random access memory shown in Figs. 11 and 12, or 13 and 14, in which the substrate is p type and the source and drain regions and the storage electrode are n⁺ type, it is possible to adopt an alternative structure in which the substrate is n type, and the source and drain regions and the storage electrode are p⁺ type.

## Claims

1. A semiconductor memory device comprising :
a semiconductor substrate (1) of one conductivity type (p) ;
a transistor (Tr) formed on the said substrate (1) and having an active portion (92) serving as a source or drain, which active portion is of the opposite conductivity type (n) ; and
a storage capacitor (SC) comprising a first relatively conductive member (5), consisting of a layer provided on the substrate within a recess (4) formed therein, a dielectric layer (6) covering the said first relatively conductive member (5) in the recess, and a second relatively conductive member (7) filling a remaining portion of the recess (4), so as to be surrounded by the said dielectric layer (6) ;
there being an electrical connection between the said second relatively conductive member (7) and the said active portion (92) of the transistor (Tr) ;
characterised in that an internal boundary region of the said recess (4), adjacent to the mouth thereof, is not covered by the said layer constituting the first relatively conductive member (5), but part of the said dielectric layer (6) extends over that region, and the said active portion (92) of the transistor provides a part of the said internal boundary region, which part is spaced from the nearest edge regions of the first relatively conductive member (5) by a predetermined interval so that a relatively insulating portion of the device isolates the said active portion (92) from the said first relatively conductive member (5).

2. A device as claimed in claim 1, wherein an insulating layer (16) is formed on the said internal boundary region so as to be interposed between that region and the said part of the dielectric layer (6), which insulating layer extends from the said active portion (92) to the said nearest edge regions.

3. A device as claimed in claim 1, wherein the said part of the dielectric layer (6) is formed directly on the said internal boundary region.

4. A device as claimed in any preceding claim, wherein the said electrical connection between the said second relatively conductive member (7) and the said active portion (92) of the transistor (Tr) is provided by a third relatively conductive member (122) extending therebetween over the substrate (1).

5. A device as claimed in any preceding claim, wherein the said first relatively conductive member (5) is made of polycrystalline silicon.

## Revendications

1. Dispositif de mémoire à semiconducteur comprenant :
un substrat semiconducteur (1) d'un type de conductivité (p) ;
un transistor (Tr) formé sur le substrat (1) qui comporte une partie active (92) qui sert de source ou de drain, cette partie active étant du type de conductivité opposé (n) ; et
une capacité de stockage (SC) qui comprend un premier élément relativement conducteur (5) qui consiste en une couche prévue sur le substrat à l'intérieur d'un évidement (4) formé dedans, une couche diélectrique (6) qui recouvre le premier élément relativement conducteur (5) dans l'évidement, et un second élément relativement conducteur (7) qui remplit une partie restante de l'évidement (4) de manière à être entouré par la couche diélectrique (6) ;

ceci constituant une connexion électrique entre le second élément relativement conducteur (7) et la partie active (92) du transistor (Tr) ;

caractérisé en ce qu'une région limite interne de l'évidement (4), adjacente à l'ouverture constituée par l'évidement, n'est pas couverte par la couche qui constitue le premier élément relativement conducteur (5), mais une partie de la couche diélectrique (6) s'étend sur cette région, et en ce que la partie active (92) du transistor constitue une partie de la région limite interne, cette partie étant espacée des régions de bord les plus proches du premier élément relativement conducteur (5) par un intervalle prédéterminé de telle sorte qu'une partie relativement isolante du dispositif isole la partie active (92) du premier élément relativement conducteur (5).

2. Dispositif selon la revendication 1, dans lequel une couche isolante (16) est formée sur la région limite interne de manière à être interposée entre cette région et la partie de la couche diélectrique (6), cette couche isolante s'étendant depuis la partie active (92) jusqu'aux régions de bord les plus proches.

3. Dispositif selon la revendication 1, dans lequel la partie de la couche diélectrique (6) est formée directement sur la région limite interne.

4. Dispositif selon l'une quelconque des revendications précédentes, dans lequel la connexion électrique entre le second élément relativement conducteur (7) et la partie active (92) du transistor (Tr) est assurée par un troisième élément relativement conducteur (122) qui s'étend entre eux sur le substrat (1).

5. Dispositif selon l'une quelconque des revendications précédentes, dans lequel le premier élément relativement conducteur (5) est réalisé en silicium polycristallin.

**Ansprüche**

1. Halbleiterspeichervorrichtung mit :

einen Halbleitersubstrat (1) von einem Leitfähigkeitstyp (p) ;

einem Transistor (Tr), der auf dem genannten Substrat (1) gebildet ist und einen aktiven Abschnitt (92) hat, der als Source oder Drain dient, welcher aktive Abschnitt vom entgegengesetzten Leitfähigkeitstyp (n) ist ; und

einem Speicherkondensator (SC), der ein erstes relativ leitendes Teil (5) umfaßt, bestehend aus einer Schicht, die auf dem Substrat innerhalb einer darin gebildeten Ausnehmung (4) vorgesehen ist, einer dielektrischen Schicht (6), welche das genannte erste relativ leitende Teil (5) in der Ausnehmung bedeckt, und einem zweiten relativ leitenden Teil (7), das einen verbleibenden Abschnitt der Ausnehmung (4) ausfüllt, um so von der genannten dielektrischen Schicht (6) umgeben zu sein ;

dabei gibt es eine elektrische Verbindung zwischen dem genannten zweiten relativ leitenden Teil (7) und dem genannten aktiven Abschnitt (92) des Transistors (Tr) ;

dadurch gekennzeichnet, daß ein interner Grenzbereich der genannten Ausnehmung (4), an deren Mund angrenzend, nicht durch die genannte Schicht bedeckt ist, die das erste relativ leitende Teil (5) bildet, daß jedoch ein Teil der genannten dielektrischen Schicht (6) sich über jenen Bereich erstreckt und der genannte aktive Abschnitt (92) des Transistors einen Teil des genannten internen Grenzbereichs bildet, welcher Teil von den nahesten Randbereichen des ersten relativ leitenden Teils (5) um ein vorbestimmtes Intervall entfernt ist, so daß ein relativ isolierender Abschnitt der Vorrichtung den genannten aktiven Abschnitt (92) von dem genannten ersten relativ leitenden Teil (5) isoliert.

2. Vorrichtung nach Anspruch 1, bei der eine isolierende Schicht (16) auf dem genannten internen Grenzbereich so gebildet ist, daß sie zwischen jenem Bereich und dem genannten Teil der dielektrischen Schicht (6) angeordnet ist, welche isolierende Schicht sich von dem genannten aktiven Abschnitt (92) zu den genannten nahesten Randbereichen erstreckt.

3. Vorrichtung nach Anspruch 1, bei der der genannte Teil der dielektrischen Schicht (6) direkt auf dem genannten internen Grenzbereich gebildet ist.

4. Vorrichtung nach einem der vorhergehenden Ansprüche, bei der die genannte elektrische Verbindung zwischen dem genannten zweiten relativ leitenden Teil (7) und dem genannten aktiven Abschnitt (92) des Transistors (Tr) durch ein drittes relativ leitendes Teil (122) gebildet ist, welches sich dazwischen über dem Substrat (1) erstreckt.

5. Vorrichtung nach einem der vorhergehenden Ansprüche, bei vier das genannte erste relativ leitende Teil (5) aus polykristallinem Silicium hergestellt ist.

Fig. I

Tr        SC(1)      SC(2)

15    101           602  500

n+              n+                              3

91      8    92    ⊖ AR
                    ⊖
e(inv)              ⊖
                    ⊖ ⊖ ⊖ DEPLETION
                          LAYER

602                              1

Fig. 2

91   14   101   92   122  102   4

                                    15

III —·—                      —·— III

# Fig. 3

Fig. 4A

Fig. 4B

Fig. 5A

Fig. 5B

Fig. 6A

Fig. 6B

Fig. 7A

Fig. 7B

## Fig.8A

## Fig.8B

## Fig. 9A

## Fig. 9B

## Fig. 10A

p TYPE
MOS TRANSISTOR

p⁺ REGION

p⁺ REGION

n TYPE LAYER
(EPITAXIAL)

p TYPE LAYER

## Fig. 10B

n⁺ REGION

p⁺ REGION

p TYPE LAYER

13

*Fig. 11*

*Fig. 12*

# Fig. 13

# Fig. 14

*Fig. 15A*

*Fig. 15B*

*Fig. 16A*

*Fig. 16B*

*Fig. 17A*

*Fig. 17B*

# Fig. 18A

# Fig. 18B

# Fig. 19A

# Fig. 19B

# Fig. 20A

# Fig. 20B